# EUROPÄISCHE PATENTSCHRIFT

(11) **EP 2 824 839 B1**
(45) Veröffentlichungstag und Bekanntmachung des Hinweises auf die Patenterteilung: **07.09.2016**
(21) Anmeldenummer: 14176058.7
(22) Anmeldetag: 08.07.2014
(51) Int. Cl.: H03K 17/96, H03K 17/955, G06F 3/0362, G06F 3/0354, G06F 3/0338

(54) **Vorrichtung und Verfahren zur Bedienung eines elektrischen Verbrauchers**
Device and method for operating an electric consumer
Dispositif et procédé de fonctionnement d'un consommateur électrique

(30) Priorität: 09.07.2013 DE 102013107230
(43) Veröffentlichungstag der Anmeldung: 14.01.2015
(73) Patentinhaber: Becker-Antriebe GmbH, 35764 Sinn (DE)
(72) Erfinder: Happ, Patrick, 35764 Sinn (DE)
(74) Vertreter: Müller, Eckhard

(56) Entgegenhaltungen:
- EP-A2- 1 477 351
- WO-A1-2011/082745
- DE-A1-102005 002 952
- DE-A1-102010 014 462
- DE-U1-202010 007 687
- DE-U1-202012 103 361
- US-A1- 2008 257 706
- US-A1- 2009 009 491
- US-A1- 2010 253 653
- Anonymous: "Microchip Technology's GestIC: An E-Field Based Competitor (or Companion) to Camera-Based Gesture Technology | www.bdti.com", , 16. Dezember 2012 (2012-12-16), XP055153236, Gefunden im Internet: URL:http://www.bdti.com/InsideDSP/2012/12/ 18/Microchip [gefunden am 2014-11-14]

## Beschreibung

Die Erfindung betrifft eine Vorrichtung und ein Verfahren zur Bedienung eines elektrischen Verbrauchers, mit einer eine Sensorfläche aufweisenden, felderzeugenden sowie Feldänderungen erfassenden berührungslosen Sensoreinheit zur Erfassung von Gesten eines Benutzers, insbesondere von Hand- oder Fingerbewegungen, und einer Auswerte- und Steuereinheit für den Empfang und Auswertung der Signale der Sensoreinheit sowie zur Steuerung des elektrischen Verbrauchers.

Aus der WO 2011/082745 A1 ist ein Bedien- und/oder Steuerelement mit einem kapazitiven Sensor bekannt, mit einem auf einem dreidimensionalen Element (2) angeordneten Sensor, der mit mindestens einem kapazitiven Sensorelement zur Annäherungserkennung ausgestattet ist. Der dreidimensionale Sensor weist eine Mehrzahl von separaten Sensorfeldern auf, die zumindest in Richtung eines Bedienraums und in vorgegebenen Richtungen seitlich dazu so ausgerichtet sind, dass eine Annäherung oder eine Berührung des Bedieners innerhalb des Bedienraums dreidimensional selektiv detektierbar ist.

Aus der EP 1477351 A2 ist eine Bedieneinrichtung für ein Fahrzeugdach bekannt, welche eine Sensorflächenanordnung zur Erfassung der Anwesenheit und/oder Bewegung einer Hand oder eines Teils einer Hand eines Bedieners innerhalb eines Erfassungsbereichs der Sensorflächenanordnung aufweist. Die Bedieneinrichtung stellt ein elektrisches Ansteuersignal bereit, welches auf Basis der Erfassung einer von dem Benutzer ausgeführten Geste wenigstens eine Fahrzeugkomponente ansteuert. Dabei sind Funktionsflächen der Bedieneinrichtung so ausgebildet, dass sie beispielsweise eine Hand oder einen Finger des Benutzers sanft führt und dabei der natürlichen Bewegung aus dem Handgelenk folgt.

Die US 2010/253653 A1 offenbart einen virtuellen Knopf, der mit mehreren berührungssensitiven Sensoren korrespondiert und welcher dazu dient, einen Finger des Benutzers entlang eines vorbestimmten Pfads zu leiten, welcher mit der Anordnung der Berührungssensoren korrespondiert.

Eine derartige Vorrichtung ist beispielsweise aus der DE 20 2010 007 687 U1 bekannt. Mit Hilfe einer derartigen Bedienungsvorrichtung, welche mit einem Körperteil, insbesondere mit der Hand oder zumindest einem Finger, betätigbar ist, kann ein motorisch angetriebener Rollladen, Jalousie, Markise oder Rolltor bedient werden. Die Bedienungsvorrichtung erkennt eine Bewegungsrichtung und/oder eine Bewegungsgeschwindigkeit des Körperteils und ordnet diese einer Funktion und/oder einer Stellung des Rollladens, der Jalousie, der Markise oder des Rolltors zu.

Aus der DE 10 2010 014 462 A1 ist ferner eine Steuereinrichtung bekannt, welche mittels einer Sensoreinheit über Infrarot Handbewegungen erfasst. Der bei der Bewegung erzeugte Signalverlauf wird mit einem in der Steuereinrichtung abgespeicherten Signalverlauf verglichen, und ein Verbraucher in Abhängigkeit von dem Vergleich der Signalverläufe angesteuert. Die Sensoreinheit hat zudem eine Kompensationseinheit zur Kompensation von Umgebungseinflüssen.

Als Sensortechnologie wird hier beispielsweise die GestlC® Technologie der Microchip Technology Inc., 2355 West Chandler Blvd., Chandler, Arizona, USA 85224-6199 genannt, wie sie beispielsweise unter http://www.microchip.com/pagehandler/enus/technology/gestic/technology/home.html beschrieben ist. Diese Technologie kann dreidimensionale Hand- oder Fingerbewegungen bzw. -gesten zuverlässig bis zu einer Entfernung von ungefähr 15 Zentimetern anhand von Änderungen des von einer Sensoreinheit erzeugten elektrischen Feldes erkennen und auswerten. Grundsätzlich wird bei dieser Technologie zwar die Änderung eines elektrischen Feldes erkannt. Im Rahmen der Erfindung sollen allerdings auch Änderungen anderer Felder, wie beispielsweise eines Wärmefeldes oder dergleichen inkludiert sein.

Nachteilig bei den bekannten Steuereinrichtungen ist, dass die Hand- oder Fingerbewegungen bzw. -gesten zum Erzeugen eines in der Steuereinrichtung hinterlegten, beispielsweise abgespeicherten, Signalverlaufs dem Bediener bzw. Benutzer vorher bekannt sein müssen. Weiterhin von Nachteil ist, dass Bewegungen bzw. Gesten wie beispielsweise Hand- oder Vorhangbewegungen oder -gesten im Erfassungsbereich der Bedienvorrichtung falsch interpretiert werden und somit zu Fehlsteuerungen eines elektrischen Verbrauchers führen können. Insbesondere bei der aus der DE 10 2010 014 462 A1 bekannten Steuereinrichtung ist es von Nachteil, dass die Abdeckung bzw. der Aufsatz für Infrarotlicht durchlässig sein muss oder Aussparungen bzw. Löcher für die Sende- und Empfangsdioden vorgesehen werden müssen.

Ausgehend hiervon liegt der Erfindung die Aufgabe zugrunde, eine Vorrichtung sowie ein Verfahren zur Bedienung eines elektrischen Verbrauchers, beispielweise eines motorisch angetriebenen Rollladens, derart weiterzubilden, dass sie eine Verbesserung der Bewegungs- bzw. Gestenerkennung und eine einfache sowie intuitive Bedienung ermöglicht.

Zur Lösung dieser Aufgabe wird erfindungsgemäß eine Vorrichtung zur Bedienung eines elektrischen Verbrauchers mit den Merkmalen des Anspruchs 1 vorgeschlagen. Vorteilhafte Ausgestaltungen der Erfindung sind Gegenstand von Unteransprüchen.

Dadurch, dass der wenigstens eine Aufsatz auf der Sensorfläche eine dreidimensionale Form aufweist, wird durch diese dreidimensionale Form dem Benutzer eine Bewegung bzw. Geste vorgegeben, die er intuitiv durchführt. Diese Geste bzw. Bewegung, insbesondere Hand- oder Fingerbewegung bzw. -geste, des Bedieners bzw. Benutzers wird also durch die dreidimensionale Form an oder auf dem Aufsatz intuitiv herbeigeführt. Eine dreidimensionale Bewegung bzw. Geste an oder auf dem Aufsatz wird sicherer erkannt als eine zweidimensionale Bewegung, da im Vergleich ein weiterer Parameter, nämlich eine 3. Dimension, zur Auswertung der durch die vorzugsweise mit der Hand oder Finger erzeugten Bewegung zur Verfügung steht. Die Vorrichtung ermöglicht somit eine wesentliche Verbesserung der Bewegungserkennung.

Um eine dreidimensionale Geste oder Bewegung an oder auf dem Aufsatz herbeizuführen, weist dieser erfindungsgemäß mindestens eine Vertiefung und/oder Erhöhung zur Vorgabe mindestens einer Bewegung, insbesondere Hand- oder Fingerbewegung, des Bedieners bzw. Benutzers auf. Die dadurch entstehende dreidimensionale Bewegung bzw. Gestik trägt wesentlich zur Verbesserung der Bewegungserkennung bei, da die vorzugsweise Hand oder Finger des Bedieners bzw. Benutzers in der mindestens einen vorgegebenen Vertiefung und/oder Erhöhung geführt und somit eine dreidimensionale Bewegung bzw. Gestik erzwungen wird. Der Bediener bzw. Benutzer wird zu einer intuitiven Hand- oder Fingerbewegung an oder auf dem Aufsatz angeleitet. Dabei ist es von Vorteil, dass die durchzuführenden Hand-oder Fingerbewegungen dem Bediener bzw. Benutzer vorher nicht bekannt sein müssen, da die dreidimensionale Form des Aufsatzes eine intuitive Bewegung der Hand oder des Fingers hervorruft.

Um mindestens eine dreidimensionale Bewegung bzw. Gestik an oder auf dem Aufsatz herbeizuführen, weist die mindestens eine Vertiefung und/oder Erhöhung an oder auf dem Aufsatz erfindungsgemäß einen dreidimensionalen Verlauf auf. Es sind somit verschiedene dreidimensionale Gestaltungsformen des Aufsatzes möglich, welche zu einer der Gestaltung entsprechenden und durch diese vorgegebenen, dreidimensionalen Bewegung bzw. Gestik führt.

Die Erfassung einer dreidimensionalen Bewegung bzw. Gestik an oder auf dem Aufsatz erfolgt durch zumindest einen in der Sensoreinheit vorhandenen berührungslosen Sensor. Der Sensor erzeugt über der Sensorfläche ein elektrisches Feld, welches den gesamten Aufsatz sowie den im Wesentlichen darüberliegenden Bereich erfasst. Die durch den Bediener bzw. Benutzer erzeugten Bewegungen an oder auf dem Aufsatz, insbesondere Hand- oder Fingerbewegungen, beeinflussen und verändern das elektrische Feld. Diese Änderungen werden wiederum vom berührungslosen Sensor über die Sensorfläche erfasst und durch eine der Sensoreinheit nachgeschaltete Auswerteinheit erkannt und ausgewertet. Als Sensortechnologie wird hier, wie bereits eingangs erwähnt, beispielsweise die GestIC® Technologie der Microchip Technology Inc., 2355 West Chandler Blvd., Chandler, Arizona, USA 85224-6199 genannt. Diese Technologie kann dreidimensionale Hand- oder Fingerbewegungen zuverlässig bis zu einer Entfernung von ungefähr 15 Zentimetern erkennen und auswerten.

Die Sensorfläche erstreckt sich dabei flächig, vorzugsweise rechteckig, mit zumindest einer der Sensorflächenform angepassten Sendeelektrode und in der Mitte sowie im äußeren Bereich der Sensorfläche angeordneten Empfangselektroden. Die Sensorfläche besteht aus zumindest einer Sendeelektrode zur Erzeugung eines elektrischen Feldes gegenüber einer elektrischen Massefläche sowie aus mehreren Empfangselektroden zur Erfassung dieses elektrischen Feldes. Bei der GestIC® Technologie der Microchip Technology Inc., Chandler, USA sind dazu insgesamt fünf Empfangselektroden für eine Gestenerkennung vorgesehen, wobei eine der insgesamt fünf Empfangselektroden primär zur Tasterkennung, d. h. zum Erkennen der Bedienung eines Tasters oder eines Schalters wie beispielsweise eines Ein-Aus-Bedienknopfes, und zur Abstandsmessung vorgesehen ist. Dabei erstreckt sich die Sensorfläche in einer zweidimensionalen Ebene, beispielsweise flächig auf einer Leiterplatte oder dergleichen, mit einer der Sensorflächenform angepassten Sendeelektrode und in der Mitte sowie im äußeren Bereich der Sensorfläche angeordneten Empfangselektroden.

Weiterhin erstreckt sich die Sensorfläche über den dreidimensionalen Aufsatz, vorzugsweise folgt die Sensorfläche der Form des Aufsatzes. Die Sensorfläche besteht aus zumindest einer Sendeelektrode zur Erzeugung eines elektrischen Feldes gegenüber einer elektrischen Massefläche sowie aus mehreren Empfangselektroden zur Erfassung dieses elektrischen Feldes. Bei der GestIC® Technologie der Microchip Technology Inc., Chandler, USA sind dazu insgesamt fünf Empfangselektroden für eine Gestenerkennung vorgesehen, wobei eine der insgesamt fünf Empfangselektroden primär zur Tasterkennung, d. h. zum Erkennen der Bedienung eines Tasters oder eines Schalters wie beispielsweise eines Ein-Aus-Bedienknopfes, und zur Abstandsmessung vorgesehen ist. Dabei sind die Sende- und/oder Empfangselektroden der Sensorfläche vorzugsweise in der dreidimensionalen Form des Aufsatzes angeordnet. Insbesondere die Empfangselektroden der Sensorfläche werden zur Erkennung verschiedener Bewegungsformen wie Gesten, Tastbedienung und/oder Abstandsmessung dreidimensional, vorzugsweise der Form des Aufsatzes folgend, angeordnet während sich die Sendeelektrode vorzugsweise in einer zweidimensionalen Ebene erstreckt, beispielsweise flächig auf einer Leiterplatte. Ferner kann die Sendeelektrode auch eine dreidimensionale Form aufweisen, wenn dadurch beispielsweise die Erfassung des elektrischen Feldes durch die Empfangselektroden verbessert wird.

Dabei ist die mindestens eine Bewegung, insbesondere Hand- oder Fingerbewegung, des Bedieners bzw. Benutzers an oder auf dem Aufsatz mindestens einer Funktion und/oder einer Stellung des elektrischen Verbrauchers zugeordnet. Einer Auf- oder Abbewegung einer Hand oder eines Fingers an oder auf dem Aufsatz kann beispielweise eine Auf- oder Abbewegung eines elektrischen Verbrauchers, wie beispielsweise ein Rollladen oder ein Garagentor, oder eine Helligkeitsänderung eines beispielsweise elektrischen Beleuchtungsgerätes zugeordnet werden. Ebenso kann beispielsweise eine Kreisbewegung mit der Hand oder dem Finger an oder auf dem Aufsatz je nach Richtung einer Bewegungsfunktion und/oder einer Stellung des elektrischen Verbrauchers, wie beispielsweise ein Rollladen oder ein Garagentor, und/oder einer Helligkeitsänderung eines beispielsweise elektrischen Beleuchtungsgerätes zugeordnet werden.

Weiterhin ist die Geschwindigkeit der mindestens einen Bewegung, insbesondere Hand- oder Fingerbewegung, des Bedieners bzw. Benutzers an oder auf dem Aufsatz mindestens einer Bewegungs- und/oder Verstellgeschwindigkeit des elektrischen Verbrauchers zugeordnet. Einer schnellen Auf- oder Abbewegung einer Hand oder eines Fingers an oder auf dem Aufsatz kann beispielweise eine Auf- oder Abbewegung mit höherer Geschwindigkeit eines elektrischen Verbrauchers, wie beispielsweise ein Rollladen oder ein Garagentor, zugeordnet werden. Ebenso kann beispielsweise eine schnelle Kreisbewegung mit der Hand oder dem Finger an oder auf dem Aufsatz eine höhere Umdrehungsgeschwindigkeit des elektrischen Verbrauchers, wie beispielsweise ein Lüfter, zugeordnet werden.

Nach einer vorteilhaften Ausgestaltung der Erfindung weist die Vorrichtung eine Anzeige, beispielsweise eine LED-Anzeige, auf, welche den Abstand einer Bewegung des Bedieners bzw. Benutzers, insbesondere die einer Hand oder eines Fingers, zum Aufsatz anzeigt. Beispielsweise leuchtet die Anzeige heller, je näher sich eine Hand oder ein Finger dem Aufsatz der Vorrichtung nähert. Einerseits signalisiert es dem Bediener bzw. Benutzer, dass sich dessen Hand oder Finger im Erfassungsbereich der Bedienvorrichtung befindet, andererseits gibt die Anzeige eine Orientierungshilfe bei der Bedienung in schwach beleuchteten oder dunklen Bereichen, in welchem die Bedienvorrichtung montiert ist.

Bewegungen sind in der Regel Hand- oder Fingerbewegungen eines Bedieners bzw. Benutzers in Form einer Person. Dabei kann es sich bei dem Aufsatz auch um ein zumindest in Teilen bewegliches Vorsatzmodul, beispielsweise eines an oder auf dem Aufsatz aufgebrachten Miniaturrollladens, handeln, welcher aber letztendlich durch mindestens eine Hand- oder Fingerbewegung vom Bediener bzw. Benutzer bewegt wird.

Nach einer vorteilhaften Ausführung ist der Aufsatz knaufartig ausgebildet und weist einen eingeschnürten Bereich zur Vorgabe der Führung einer Hand- oder Fingerbewegung und eine dem Benutzer zugewandte Stirnseite als vorzugsweise eben ausgebildetes Betätigungsfeld auf. Die knaufartige Form veranlasst den Bediener bzw. Benutzer dazu, dass dieser intuitiv mit der den Knauf umgreifenden Hand eine Drehbewegung ausführt, um eine Funktion und/oder eine Stellung in Form einer Ausoder Fortführung einer Bewegung oder einer Änderung der Bewegungsrichtung oder Bewegungs- und/oder Verstellgeschwindigkeit am elektrischen Verbraucher, wie beispielsweise ein Rollladen oder ein Garagentor, oder einer Helligkeitsänderung eines beispielsweise elektrischen Beleuchtungsgerätes herbeizuführen. Das vorzugsweise ebene Betätigungsfeld an der dem Bediener bzw. Benutzer zugewandten Knaufstirnseite verbindet dieser intuitiv mit der Bedienung eines Tasters oder eines Schalters, ähnlich eines Ein-Aus-Bedienknopfes, wie man es von elektrischen Geräten her kennt oder eines Not-Aus-Bedienknopfes, wie man es von Maschinen und Anlagen her kennt. Dabei muss das Betätigungsfeld an der Knaufstirnseite in seiner Form nicht zwingend eben oder plan sein, es kann auch Vertiefungen und/oder Erhöhungen aufweisen.

In einer Weiterbildung der Erfindung ist der Aufsatz kegelförmig ausgebildet mit einer in die Kegelmantelfläche eingelassenen, exzentrisch zur Kegelachse verlaufenden spiral- bzw. schneckenförmigen Vertiefung. Diese spiral bzw. schneckenförmige Vertiefung gibt bei dieser Ausführung den Verlauf für mindestens eine definierte Fingerbewegung vor und veranlasst den Bediener bzw. Benutzer dazu, intuitiv mit dem Finger eine dem Verlauf der Vertiefung folgende Bewegung auszuführen, um eine Funktion und/oder eine Stellung in Form einer Aus- oder Fortführung einer Bewegung oder einer Änderung der Bewegungsrichtung oder Bewegungs- und/oder Verstellgeschwindigkeit am elektrischen Verbraucher, wie beispielsweise ein Rollladen oder ein Garagentor, oder eine Helligkeitsänderung eines beispielsweise elektrischen Beleuchtungsgerätes herbeizuführen. Dabei kann die dem Verlauf folgende Fingerbewegung im oder gegen den Uhrzeigersinn erfolgen.

Nach einer weiteren vorteilhaften Ausführungsform weist der Aufsatz eine im Wesentlichen ebene Basisfläche mit einem darauf angeordneten, etwa schienenförmigen, Führungsteil mit darin längsverlaufenden Vertiefungen auf. Die ebene Basisfläche wird durch das schienenförmige Führungsteil in zwei Bereiche unterteilt. Diese beiden Bereiche der ebenen Basisfläche verbindet der Bediener bzw. Benutzer intuitiv mit der Bedienung zweier Taster oder eines Schalters, wobei die beiden Bereiche der ebenen Basisfläche jeweils eine Schalterstellung, beispielsweise die Schaltzustände eines Kippschalters "Ein" oder "Aus", repräsentieren und durch Berühren oder Antippen mit dem Finger oder der Hand eine Funktion und/oder eine Stellung in Form einer Aus- oder Fortführung einer Bewegung oder einer Änderung der Bewegungsrichtung oder Bewegungs- und/oder Verstellgeschwindigkeit am elektrischen Verbraucher, wie beispielsweise ein Rollladen oder ein Garagentor, oder eine Helligkeitsänderung eines beispielsweise elektrischen Beleuchtungsgerätes herbeiführen.

Weiterhin weist das schienenförmige Führungsteil auf der Oberseite ein weiteres, vorzugsweise ebenes Betätigungsfeld auf, welches ebenfalls durch Berühren oder Antippen mit dem Finger oder der Hand einer Funktion und/oder einer Stellung in Form einer Aus- oder Fortführung einer Bewegung oder einer Änderung der Bewegungsrichtung oder Bewegungs- und/oder Verstellgeschwindigkeit am elektrischen Verbraucher oder einer Helligkeitsänderung eines beispielsweise elektrischen Beleuchtungsgerätes zugeordnet werden kann. Die beiden am schienenförmigen Führungsteil längsverlaufenden Vertiefungen geben den Verlauf für Fingerbewegungen vor und veranlassen den Bediener bzw. Benutzer dazu, dass dieser intuitiv mit dem Finger dem Verlauf der Vertiefungen folgt und dadurch eine Funktion und/oder eine Stellung in Form einer Aus- oder Fortführung einer Bewegung oder einer Änderung der Bewegungsrichtung oder Bewegungs- und/oder Verstellgeschwindigkeit am elektrischen Verbraucher, wie beispielsweise ein Rollladen oder ein Garagentor, oder eine Helligkeitsänderung eines beispielsweise elektrischen Beleuchtungsgerätes herbeiführt, je nachdem auf welcher Seite des Führungsteils und in welche Richtung der Finger in den Vertiefungen bewegt wird.

Nach einer weiteren vorteilhaften Ausgestaltung weist der Aufsatz die Form eines flachen Betätigungsfeldes mit einer darin eingelassenen S-förmigen Vertiefung auf. Die Vertiefung gibt bei dieser Ausführung den Verlauf für mindestens eine definierte Fingerbewegung vor und veranlasst den Bediener bzw. Benutzer dazu, dass dieser intuitiv mit dem Finger eine dem Verlauf der Vertiefung folgende Bewegung ausführt, um eine Funktion und/oder eine Stellung in Form einer Aus- oder Fortführung einer Bewegung oder einer Änderung der Bewegungsrichtung oder Bewegungs- und/oder Verstellgeschwindigkeit am elektrischen Verbraucher, wie beispielsweise ein Rollladen oder ein Garagentor, oder eine Änderung der Helligkeit und/oder der Farbintensitäten der Beleuchtungsfarben eines beispielsweise elektrischen Beleuchtungsgerätes herbeizuführen. Dabei kann die Form der Vertiefung durchaus auch die Form anderer Buchstaben des Alphabets sowie Symbole, Zeichen oder Zahlen, auch in Kombination zueinander, aufweisen. Die flachen Teile des Betätigungsfeldes können beispielsweise mit einer Start- oder Stoppfunktion, ähnlich eines Ein-Aus-Bedienknopfes, wie man es von elektrischen Geräten her kennt, belegt werden.

Ebenso kann die S-förmige Vertiefung zur Steuerung für elektrische Beleuchtungsgeräte in Form von mindestens einem Leuchtmittel in den Farben Rot, Grün und Blau (RGB), beispielsweise einer RGB-Leuchtdiode, verwendet werden. Durch eine dem Verlauf der Vertiefung folgende Fingerbewegung können die Farbintensitäten des mindestens einen Leuchtmittels derart verändert werden, dass die Farben Rot, Grün und Blau miteinander gemischt werden, je nachdem in welche Richtung der Finger in der Vertiefung bewegt wird. Es versteht sich, dass auch andere Formen der im Aufsatz eingelassenen Vertiefungen, wie beispielsweise Buchstaben, Symbole, Zeichen oder Zahlen jeglicher Art, für eine zuvor beschriebene Steuerung für elektrische Beleuchtungsgeräte verwendet werden können.

Dabei bestehen der Aufsatz und/oder die Sensorfläche aus verschiedenen Materialien, vorzugsweise aus Glas und/oder Kunststoff und/oder Karbon und/oder Holz oder dergleichen. Weitere Materialien oder Materialkombinationen sind möglich. Das Material muss so beschaffen sein, dass es für das vom berührungslosen Sensor erzeugte elektrische Feld zumindest bereichsweise durchlässig ist. Elektrisch leitende Materialien im Aufsatz beeinflussen zwar das erzeugte elektrische Feld, werden aber durch ein Kalibrierverfahren in der Vorrichtung kompensiert, so dass eine durch den Bediener bzw. Benutzer erzeugte Bewegung, insbesondere Hand- oder Fingerbewegung, auch bei eingeschränkter Materialdurchlässigkeit erkannt wird. Dabei ist es von wesentlichem Vorteil, dass das Material nicht für Infrarotlicht durchlässig sein muss und dafür keine Aussparungen oder dergleichen wie beispielsweise Löcher vorgesehen werden müssen.

Das Material des dreidimensionalen Aufsatzes ist dabei für ein Bedrucken und/oder Beschriften ausgebildet. Aufgedruckte Buchstaben, Symbole, Zeichen, Zahlen oder dergleichen können die intuitive Bedienung der Vorrichtung durch den Bediener bzw. Benutzer unterstützen und erweitern gegebenenfalls die Bedienungsmöglichkeiten der Vorrichtung.

Bei dem elektrischen Verbraucher kann es sich um einen Rollladen, eine Jalousie, eine Markise, ein Garagentor, einen Lüfter oder ein elektrisches Beleuchtungsgerät handeln. Dabei ist der Rollladen, die Jalousie, die Markise, das Garagentor und der Lüfter vorzugsweise ein elektrisch oder motorisch angetriebener Verbraucher.

Die Erfindung betrifft auch ein Verfahren mit den Merkmalen des Anspruchs 15 zur Bedienung eines elektrischen Verbrauchers, mit einer eine Sensorfläche aufweisenden Sensoreinheit zur Erfassung von Bewegungen eines Benutzers, insbesondere von Hand- oder Fingerbewegungen, und einer Auswerte- und Steuereinheit für den Empfang und Auswertung der Signale der Sensoreinheit sowie zur Steuerung des elektrischen Verbrauchers.

Der durch die eine Hand- oder Fingerbewegung an oder auf dem dreidimensionalen Aufsatz erzeugte Signalverlauf wird mit wenigstens einem vorgegebenen, beispielsweise abgespeicherten, Signalverlauf verglichen und der elektrische Verbraucher in Abhängigkeit von dem Vergleich der Signalverläufe angesteuert. Dadurch, dass eine vorgegebene dreidimensionale Bewegung bzw. Gestik an oder auf dem Aufsatz notwendig ist, um eine Funktion wie beispielsweise eine Bewegung am elektrischen Verbraucher zu erzeugen, werden undefinierte Bewegungen in der Nähe des Aufsatzes wie beispielsweise Hand- oder Vorhangbewegungen nicht als eine vorgegebene Bewegung interpretiert. Eine Fehlsteuerung des elektrischen Verbrauchers wie beispielsweise eines motorisch angetriebenen Rollladens wird dadurch vermieden.

Die auf den Aufsatz einwirkenden Störeinflüsse, wie beispielsweise Gegenstände auf oder vor dem Aufsatz, werden durch Kalibrieren der Signale der Sensoreinheit kompensiert. Durch den regelmäßigen Vergleich der Signale der Sensoreinheit mit dem Signal zum Erzeugen des elektrischen Feldes werden durch Anpassungen von Amplitude und Frequenz der Signale dauerhafte oder länger anstehende Störungen, wie beispielsweise ein vor der Bedienvorrichtung hängender Vorhang, durch die Auswerte- und Steuereinheit eliminiert bzw. kompensiert. Eine durch den Bediener bzw. Benutzer erzeugte Bewegung, insbesondere Hand- oder Fingerbewegung, ist eine nicht dauerhaft vorhandene Beeinflussung bzw. Änderung des elektrischen Feldes und wird beispielsweise von der GestIC® Technologie der Microchip Technology Inc., Chandler, USA als eine dreidimensionale Hand- oder Fingerbewegung erkannt, auch wenn auf oder vor dem Aufsatz dauerhafte Störeinflüsse vorhanden sind.

Es versteht sich, dass sich die vorteilhaften Ausgestaltungen der Bedienvorrichtung selbstverständlich auch in Kombination mit dem Verfahren zur Bedienung einer solchen Vorrichtung und eine Kombination der Vorrichtungsmerkmale mit den Verfahrensmerkmalen und umgekehrt sinnvoll ist und zum Gegenstand der vorliegenden Offenbarung gehört.

Die Erfindung wird anhand einiger Ausführungsbeispiele erläutert.

Es zeigen:
- Fig. 1: ein Ausführungsbeispiel der Bedienvorrichtung in perspektivischer Ansicht mit einem knaufförmig ausgebildeten Aufsatz,
- Fig. 2: ein Ausführungsbeispiel der Bedienvorrichtung in perspektivischer Ansicht mit einem kegelförmig ausgebildeten Aufsatz,
- Fig. 3: ein Ausführungsbeispiel der Bedienvorrichtung in perspektivischer Ansicht mit ebener Basisfläche und darauf angeordnetem, schienenförmigen Führungsteil als Aufsatz,
- Fig. 4: ein Ausführungsbeispiel der Bedienvorrichtung in perspektivischer Ansicht mit flachem Betätigungsfeld und darin eingelassenen S-förmigen Vertiefung als Aufsatz.

Die in den Figuren dargestellten Bedienvorrichtungen 1 dienen zur weiteren Verdeutlichung des Grundprinzips, wobei gleiche oder gleich wirkende Elemente zumindest mit denselben Bezugszeichen versehen sind.

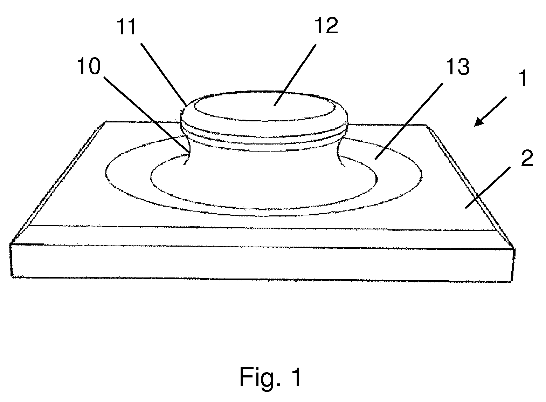

Die Bedienvorrichtung 1 gemäß Fig. 1 zeigt einen Aufsatz 2 in knaufartiger Form. Dabei weist der auf dem Aufsatz 2 dargestellte Knauf im unteren, dem des Aufsatzes 2 zugewandten Bereich, einen eingeschnürten Bereich 10 sowie eine in den Aufsatz 2 eingelassene Vertiefung 13 auf. Im oberen, in Richtung der Stirnseite des Knaufes, weist der Aufsatz 2 einen verdickten Bereich 11 auf. Diese Ausformung veranlasst den Bediener bzw. Benutzer dazu, bei der Bedienung der Vorrichtung 1 den Knauf mit der Hand zu umgreifenden und intuitiv eine drehende Handbewegung am Knauf ausführen. Mit dieser drehenden Handbewegung kann beispielsweise eine Auf- oder Abbewegung eines elektrisch angetriebenen Rollladens oder Garagentores ausgelöst oder die Umdrehungsgeschwindigkeit eines Lüfters oder die Helligkeit eines elektrischen Beleuchtungsgerätes geändert werden, je nachdem in welche Richtung die Hand am Knauf gedreht wird.

Weiterhin weist der auf dem Aufsatz 2 dargestellte Knauf auf der dem Bediener bzw. Benutzer zugewandten Stirnseite, oberhalb des verdickten Bereiches 11, ein vorzugsweise eben ausgebildetes Betätigungsfeld 12 auf. Das vorzugsweise ebene Betätigungsfeld 12 verbindet der Bediener bzw. Benutzer bei der Bedienung der Vorrichtung 1 intuitiv mit der Bedienung eines Tasters oder eines Schalters. Durch Berühren oder Antippen mit dem Finger oder der Hand kann beispielsweise ein Stoppen eines elektrisch angetriebenen Rollladens, Garagentores oder Lüfters ausgelöst oder ein elektrisches Beleuchtungsgerät ein- oder ausgeschaltet werden.

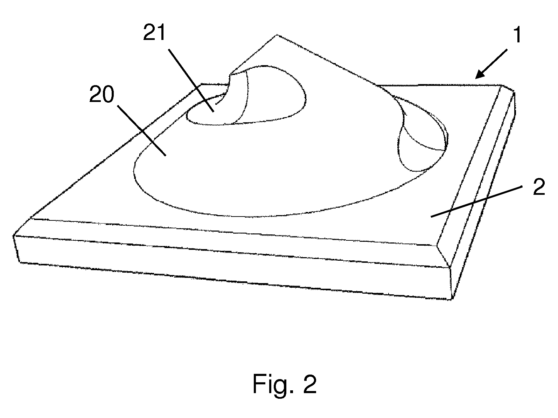

In Fig. 2 weist der Aufsatz 2 der Bedienvorrichtung 1 eine als Kegel ausgebildete Form auf. In die Kegelmantelfläche 20 ist eine, exzentrisch zur Kegelachse verlaufende, spiral- bzw. schneckenförmige Vertiefung 21 eingelassen. Die spiral- bzw. schneckenförmige Vertiefung 21 beginnt bei dem hier gewählten Ausführungsbeispiel an der Kegeloberseite und endet nach ungefähr einer Umdrehung an der Kegelunterseite. Die Vertiefung 21 gibt den Verlauf für eine Fingerbewegung vor und veranlasst den Bediener bzw. Benutzer dazu, dass dieser intuitiv mit dem Finger dem Verlauf der Vertiefung 21 folgt. Durch diese mit dem Finger erzeugte Bewegung kann beispielsweise eine Auf- oder Abbewegung eines elektrisch angetriebenen Rollladens oder Garagentores ausgelöst oder die Umdrehungsgeschwindigkeit eines Lüfters oder die Helligkeit eines elektrischen Beleuchtungsgerätes geändert werden, je nachdem in welche Richtung der Finger in der Vertiefung 21 bewegt wird.

Weiterhin verbindet der Bediener bzw. Benutzer das Berühren oder Antippen des Aufsatzes 2 mit der flachen Hand, insbesondere der als Kegel ausgebildeten Form, intuitiv mit der Bedienung eines Tasters oder eines Schalters. Damit kann beispielsweise ein Stoppen eines elektrisch angetriebenen Rollladens, Garagentores oder eines Lüfters ausgelöst oder ein elektrisches Beleuchtungsgerät ein- oder ausgeschaltet werden.

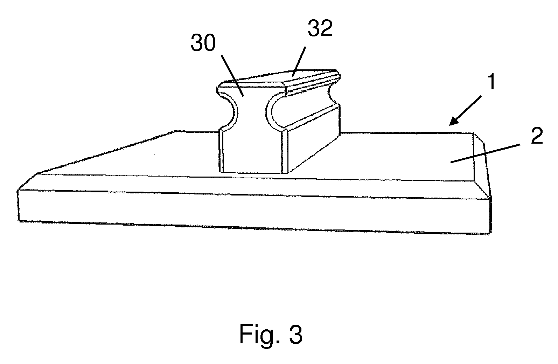

Gemäß Fig. 3 weist der Aufsatz 2 eine im Wesentlichen ebene Basisfläche mit einem darauf angeordneten schienenförmigen Führungsteil 30 auf, welche die ebene Basisfläche in zwei Bereiche unterteilt. Die beiden Bereiche der ebenen Basisfläche verbindet der Bediener bzw. Benutzer mit der Bedienung zweier Taster oder eines Schalters, wobei die beiden Bereiche der ebenen Basisfläche jeweils eine Schalterstellung, beispielsweise die Schaltzustände eines Kippschalters "Ein" oder "Aus", repräsentieren. Durch Berühren oder Antippen mit dem Finger oder der Hand in den beiden Bereichen der ebenen Basisfläche kann beispielsweise eine Auf- oder Abbewegung oder ein Stoppen eines elektrisch angetriebenen Rollladens oder Garagentores oder das Ein- oder Ausschalten eines Lüfters oder elektrischen Beleuchtungsgerätes ausgelöst werden.

Weiterhin weist das schienenförmige Führungsteil 30 an den Seiten längsverlaufende Vertiefungen 31 sowie auf der Oberseite des Führungsteils 30 ein weiteres, vorzugsweise ebenes Betätigungsfeld 32 auf. In Kombination mit den beiden Bereichen der ebenen Basisfläche kann das Betätigungsfeld 32 dazu verwendet werden, dass beispielsweise das Stoppen eines elektrisch angetriebenen Rollladens oder Garagentores durch Berühren oder Antippen des Betätigungsfeldes 32 mit dem Finger oder der Hand ausgelöst wird. Die beiden Vertiefungen 31 geben den Verlauf für Fingerbewegungen vor und veranlassen den Bediener bzw. Benutzer dazu, dass dieser intuitiv mit dem Finger dem Verlauf der Vertiefungen 31 folgt und dadurch beispielsweise eine Auf- oder Abbewegung eines elektrisch angetriebenen Rollladens oder Garagentores auslöst oder die Umdrehungsgeschwindigkeit eines Lüfters oder die Helligkeit eines elektrischen Beleuchtungsgerätes ändert, je nachdem auf welcher Seite des Führungsteils 30 und in welche Richtung der Finger in den Vertiefungen 31 bewegt wird.

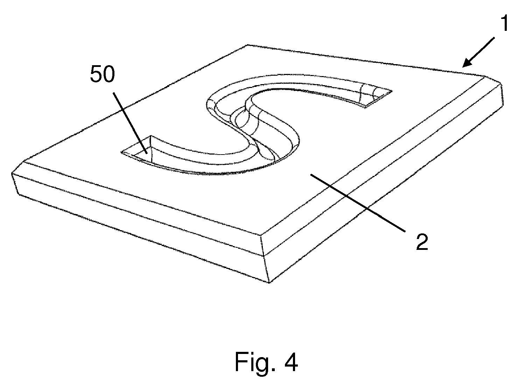

Gemäß Fig. 4 weist der Aufsatz 2 die Form eines flachen Betätigungsfeldes mit einer darin eingelassenen S-förmigen Vertiefung 50 auf. Die Vertiefung 50 gibt den Verlauf für eine Fingerbewegung vor und veranlasst den Bediener bzw. Benutzer dazu, dass dieser intuitiv mit dem Finger eine dem Verlauf der Vertiefung 50 folgende Bewegung ausführt, um beispielsweise eine Bewegung eines elektrisch angetriebenen Rollladens oder Garagentores oder die Umdrehungsgeschwindigkeit eines Lüfters oder die Helligkeit eines elektrischen Beleuchtungsgerätes zu steuern, je nachdem in welche Richtung der Finger in der Vertiefung 50 bewegt wird.

Ebenso kann die S-förmige Vertiefung 50 zur Steuerung für elektrische Beleuchtungsgeräte in Form von mindestens einem Leuchtmittel in den Farben Rot, Grün und Blau (RGB), beispielsweise einer RGB-Leuchtdiode, verwendet werden. Durch eine dem Verlauf der Vertiefung 50 folgende Fingerbewegung können die Farbintensitäten des mindestens einen Leuchtmittels derart verändert werden, dass die Farben Rot, Grün und Blau miteinander gemischt werden, je nachdem in welche Richtung der Finger in der Vertiefung 50 bewegt wird.

Weiterhin kann durch Berühren oder Antippen mit dem Finger oder der Hand auf dem flachen Teil des dreidimensionalen Aufsatzes 2 beispielsweise ein Stoppen eines elektrisch angetriebenen Rollladens oder Garagentores oder das Ein- oder Ausschalten eines Lüfters oder elektrischen Beleuchtungsgerätes ausgelöst werden.

Die gezeigten Bedienungsvorrichtungen 1 in den Figuren 1 bis 4 kommen ohne jeglichen mechanischen Taster oder Schalter sowie ohne bewegliche Teile wie beispielsweise ein Drehknopf aus, sind leicht zu reinigen und besonders robust und zuverlässig. Es müssen keine Aussparungen oder dergleichen wie beispielsweise Löcher im Aufsatz 2 der Bedienvorrichtungen 1 vorgesehen werden. Dadurch können sie auch in hygienischen Bereichen, wie beispielsweise in Krankenhäusern, eingesetzt werden oder sind für Anwendungen in Feuchtraumbereichen sehr gut geeignet. Weiterhin lassen sich mit den verschiedenen Materialien oder Materialkombinationen visuell sehr ansprechende Designs des Aufsatzes realisieren.

Als weitere Vorteile aller gezeigten Bedienungsvorrichtungen 1 sind hier zu nennen, dass die Aufsätze 2 in der Herstellung sehr kostengünstig sind, da die Basis der Bedienvorrichtung 1 immer gleich ist und sich lediglich im dem darauf angebrachten Aufsatz 2 unterscheidet. Per Software lassen sich verschiedene, an den Aufsatz 2 anpassbare, Gestiken in die Auswerte- und Steuereinheit der Bedienvorrichtung 1 programmieren.

### Bezugszeichenliste

- 1: Bedienvorrichtung
- 2: Aufsatz
- 10: eingeschnürter Bereich
- 11: verdickter Bereich
- 12: Betätigungsfeld
- 13: Vertiefung
- 20: Kegelmantelfläche
- 21: spiralförmige Vertiefung
- 30: schienenförmiges Führungsteil
- 31: längsverlaufende Vertiefungen
- 32: Betätigungsfeld
- 50: Vertiefung

## Patentansprüche

1. Vorrichtung zur Bedienung eines elektrischen Verbrauchers, mit einer eine Sensorfläche aufweisenden, felderzeugenden sowie berührungslos Feldänderungen erfassenden Sensoreinheit zur Erfassung von Gesten eines Benutzers, insbesondere von Hand- oder Fingergesten, und einer Auswerte- und Steuereinheit für den Empfang und Auswertung der Signale der Sensoreinheit sowie zur Steuerung des elektrischen Verbrauchers, wobei auf der Sensorfläche wenigstens ein dreidimensionaler Aufsatz (2) zur Herbeiführung mindestens einer intuitiven Geste des Benutzers vorgesehen ist, wobei der dreidimensionale Aufsatz dazu eine dreidimensionale Form aufweist, bei welcher der Aufsatz (2) mindestens eine Vertiefung und/oder Erhöhung zur Vorgabe der mindestens einen Geste des Benutzers aufweist, **dadurch gekennzeichnet, dass** die mindestens eine Vertiefung und/oder Erhöhung auf dem Aufsatz (2) einen dreidimensionalen Verlauf aufweist.

2. Vorrichtung nach Anspruch 1, **dadurch gekennzeichnet, dass** die Sensoreinheit Sensoren aufweist, die zur berührungslosen Erfassung einer Feldänderung ausgebildet sind.

3. Vorrichtung nach einem der vorhergehenden Ansprüche, **dadurch gekennzeichnet, dass** sich die Sensorfläche flächig, vorzugsweise rechteckig, erstreckt mit zumindest einer der Sensorflächenform angepassten Sendeelektrode und in der Mitte sowie im äußeren Bereich der Sensorfläche angeordneten Empfangselektroden.

4. Vorrichtung nach einem der vorhergehenden Ansprüche 1 oder 2, **dadurch gekennzeichnet, dass** sich die Sensorfläche über den dreidimensionalen Aufsatz (2) erstreckt, vorzugsweise folgt die Sensorfläche der Form des Aufsatzes (2).

5. Vorrichtung nach einem der vorhergehenden Ansprüche, **dadurch gekennzeichnet, dass** die mindestens eine Geste des Benutzers an oder auf dem Aufsatz (2) mindestens einer Funktion und/oder einer Stellung des elektrischen Verbrauchers zugeordnet ist.

6. Vorrichtung nach einem der vorhergehenden Ansprüche, **dadurch gekennzeichnet, dass** die Geschwindigkeit der mindestens einen Geste des Benutzers an oder auf dem Aufsatz (2) mindestens einer Bewegungs- und/oder Verstellgeschwindigkeit des elektrischen Verbrauchers zugeordnet ist.

7. Vorrichtung nach einem der vorhergehenden Ansprüche, **dadurch gekennzeichnet, dass** die Vorrichtung eine Anzeige, beispielsweise eine LED-Anzeige, aufweist, welche den Abstand einer Geste des Benutzers zum Aufsatz (2) anzeigt.

8. Vorrichtung nach einem der vorhergehenden Ansprüche, **dadurch gekennzeichnet, dass** der Aufsatz (2) knaufförmig ausgebildet ist mit einem eingeschnürten Bereich (10) zur Vorgabe der Führung einer Hand- oder Fingergeste bzw. -bewegung und eine dem Benutzer zugewandten Stirnseite als vorzugsweise eben ausgebildetes Betätigungsfeld (12) aufweist.

9. Vorrichtung nach einem der vorhergehenden Ansprüche 1 bis 7, **dadurch gekennzeichnet, dass** der Aufsatz (2) kegelförmig ausgebildet ist mit einer in die Kegelmantelfläche (20) eingelassenen, exzentrisch zur Kegelachse verlaufenden spiral- bzw. schneckenförmigen Vertiefung (21).

10. Vorrichtung nach einem der vorhergehenden Ansprüche 1 bis 7, **dadurch gekennzeichnet, dass** der Aufsatz (2) eine im Wesentlichen ebene Basisfläche mit einem darauf angeordneten schienenförmigen Führungsteil (30) und darin längsverlaufenden Vertiefungen (31) aufweist.

11. Vorrichtung nach einem der vorhergehenden Ansprüche 1 bis 7, **dadurch gekennzeichnet, dass** der Aufsatz (2) die Form eines flachen Betätigungsfeldes mit einer darin eingelassenen dreidimensionalen S-förmigen Vertiefung (50) aufweist.

12. Vorrichtung nach einem der vorhergehenden Ansprüche, **dadurch gekennzeichnet, dass** der Aufsatz (2) und/oder die Sensorfläche vorzugsweise aus Glas und/oder Kunststoff und/oder Karbon und/oder Holz oder dergleichen besteht.

13. Vorrichtung nach einem der vorhergehenden Ansprüche, **dadurch gekennzeichnet, dass** das Material der Aufsatzoberfläche für ein Bedrucken und/oder Beschriften ausgebildet ist.

14. Vorrichtung nach einem der vorhergehenden Ansprüche, **dadurch gekennzeichnet, dass** der elektrische Verbraucher ein Rollladen, eine Jalousie, eine Markise, ein Garagentor, ein Lüfter oder ein elektrisches Beleuchtungsgerät ist.

15. Verfahren zur Bedienung eines elektrischen Verbrauchers, mit einer eine Sensorfläche aufweisenden, felderzeugenden sowie berührungslos Feldänderungen erfassenden Sensoreinheit zur Erfassung von Gesten eines Benutzers, insbesondere von Hand- oder Fingergesten, und einer Auswerte- und Steuereinheit für den Empfang und Auswertung der Signale der Sensoreinheit sowie zur Steuerung des elektrischen Verbrauchers, wobei eine Hand- oder Fingergeste entsprechend einer vorgegebenen Form auf einem dreidimensionalen Aufsatz (2) durchgeführt und der erzeugte Signalverlauf beziehungsweise die Feldänderung von der Auswerte- und Steuereinheit erfasst wird und mit wenigstens einem vorgegebenen Signalverlauf beziehungsweise Feldänderung verglichen und der elektrische Verbraucher in Abhängigkeit von dem Vergleich der Signalverläufe beziehungsweise Feldänderung durch die Auswerte- und Steuereinheit angesteuert wird, wobei der Aufsatz (2) mindestens eine Vertiefung und/oder Erhöhung zur Vorgabe mindestens einer Geste des Benutzers aufweist, **dadurch gekennzeichnet, dass** die mindestens eine Vertiefung und/oder Erhöhung auf dem Aufsatz (2) einen dreidimensionalen Verlauf aufweist.

16. Verfahren nach Anspruch 15, **dadurch gekennzeichnet, dass** die auf den Aufsatz (2) einwirkenden Störeinflüsse durch Kalibrieren der Signale der Sensoreinheit kompensiert werden.

## Claims

1. Device for operating an electrical consumer, comprising a sensor unit that has a sensor surface, is field-generating and detects field changes in a touchless manner, and that serves for detecting the gestures of a user, in particular of hand or finger gestures, and comprising an evaluation and control unit for receiving and evaluating the signals of the sensor unit as well as for controlling the electrical consumer, wherein at least one three-dimensional attachment (2) for effecting at least one intuitive gesture of a user is provided on the sensor surface, wherein for that purpose the three-dimensional attachment has a three-dimensional shape, in which the attachment (2) has at least one indentation and/or elevation for prescribing at least one gesture of the user, **characterized in that** the at least one indentation and/or elevation on the attachment (2) has a three-dimensional course.

2. Device according to claim 1, **characterized in that** the sensor unit comprises sensors that are formed for the touchless detection of a field change.

3. Device according to one of the preceding claims, **characterized in that** the sensor surface extends in a planar, preferably rectangular manner with at least one transmitting electrode that is adjusted to the sensor surface shape, and with receiving electrodes that are arranged in the center as well as in the outer area of the sensor surface.

4. Device according to one of the preceding claims1 or 2, **characterized in that** the sensor surface extends across the three-dimensional attachment (2), with the sensor surface preferably following the shape of the attachment (2).

5. Device according to one of the preceding claims, **characterized in that** the at least one gesture of the user at or on the attachment (2) is assigned to at least one function and/or one position of the electrical consumer.

6. Device according to one of the preceding claims, **characterized in that** the speed of the at least one gesture of the user at or on the attachment (2) is assigned to at least one movement and/or adjustment speed of the electrical consumer.

7. Device according to one of the preceding claims, **characterized in that** the device comprises a display, for example a LED display, which displays the distance of a gesture of the user to the attachment (2).

8. Device according to one of the preceding claims, **characterized in that** the attachment (2) is formed in a knob-shaped manner with a constricted area (10) for predetermining the guidance of a hand or finger gesture or motion, and **in that** it has a front side facing towards the user as a preferably flat formed operating field (12).

9. Device according to one of the preceding claims 1 to 7, **characterized in that** the attachment (2) is formed in a conical manner with a helical or vaulted indentation (21) that is inset into the cone lateral surface (20) and extends off-center with respect to the cone axis.

10. Device according to one of the preceding claims 1 to 7, **characterized in that** the attachment (2) has a substantially even base area, with a rail-shaped guiding part (30) being arranged thereon, and indentations (31) extending therein in the longitudinal direction.

11. Device according to one of the preceding claims 1 to 7, **characterized in that** the attachment (2) has the shape of a flat operating field with a three-dimensional S-shaped indentation (50) being inset therein.

12. Device according to one of the preceding claims, **characterized in that** the attachment (2) and/or the sensor surface is preferably made of glass and/or plastic and/or carbon and/or wood or the like.

13. Device according to one of the preceding claims, **characterized in that** the material of the attachment surface is formed for being printed on and/or being written on.

14. Device according to one of the preceding claims, **characterized in that** the electrical consumer is a roller shutter, a Venetian blind, an awning, a garage gate, a fan or an electric illumination device.

15. Method for operating an electrical consumer, comprising a sensor unit that has a sensor surface, is field-generating and detects field changes in a touchless manner, and that serves for detecting the gestures of a user, in particular of hand or finger gestures, and comprising an evaluation and control unit for receiving and evaluating the signals of the sensor unit as well as for controlling the electrical consumer, wherein a hand or finger gesture is performed in accordance with a predetermined shape on a three-dimensional attachment (2) and the generated signal course or the field change is detected by the evaluation and control unit and is compared to at least one predetermined signal course or field change, and the electrical consumer is selected depending on the comparison of the signal courses or field change by the evaluation and control unit, wherein the attachment (2) has at least one indentation and/or elevation for prescribing at least one gesture of the user, **characterized in that** the at least one indentation and/or elevation on the attachment (2) has a three-dimensional course.

16. Method according to claim 15, **characterized in that** any interferences acting on the attachment (2) are compensated by calibrating the signals of the sensor unit.

## Revendications

1. Dispositif pour la commande d'un consommateur électrique, comprenant une unité de capteur présentant une surface de capteur, laquelle est capable de générer un champ et de détecter des variations de champ sans contact afin de détecter des gestes d'un utilisateur, en particulier des gestes de la main ou des doigts, et une unité d'évaluation et de commande destinée à recevoir et à évaluer les signaux de l'unité de capteur et à commander le consommateur électrique, dans lequel au moins un embout tridimensionnel (2) destiné à provoquer au moins un geste intuitif de l'utilisateur est prévu sur la surface de capteur, dans lequel l'embout tridimensionnel présente à cette fin une forme tridimensionnelle selon laquelle l'embout (2) présente au moins une cavité et/ou un bossage pour la définition de l'au moins un geste de l'utilisateur, **caractérisé en ce que** l'au moins une cavité et/ou l'au moins un bossage sur l'embout (2) présente un tracé tridimensionnel.

2. Dispositif selon la revendication 1, **caractérisé en ce que** l'unité de capteur comporte des capteurs conçus pour détecter sans contact une variation de champ.

3. Dispositif selon l'une des revendications précédentes, **caractérisé en ce que** la surface de capteur s'étend de façon planaire, de préférence rectangulaire, avec au moins une électrode d'émission adaptée à la forme de la surface de capteur et avec des électrodes de réception disposées au milieu tout comme dans la région extérieure de la surface de capteur.

4. Dispositif selon l'une des revendications précédentes 1 ou 2, **caractérisé en ce que** la surface de capteur s'étend sur l'embout tridimensionnel (2), la surface de capteur épousant de préférence la forme de l'embout (2).

5. Dispositif selon l'une des revendications précédentes, **caractérisé en ce que** l'au moins un geste de l'utilisateur au niveau de ou sur l'embout (2) est attribué à au moins une fonction et/ou à une position du consommateur électrique.

6. Dispositif selon l'une des revendications précédentes, **caractérisé en ce que** la vitesse de l'au moins un geste de l'utilisateur au niveau de ou sur l'embout (2) est attribuée à au moins une vitesse de mouvement et/ou de réglage du consommateur électrique.

7. Dispositif selon l'une des revendications précédentes, **caractérisé en ce que** le dispositif comporte un écran, par exemple un écran LED, lequel indique l'écart entre un geste de l'utilisateur et l'embout (2).

8. Dispositif selon l'une des revendications précédentes, **caractérisé en ce que** l'embout (2) est conçu en forme de bouton, avec une région rétrécie (10) permettant de définir le guidage d'un geste ou mouvement de la main ou des doigts et présente une face frontale tournée vers l'utilisateur, comme champ de commande (12) conçu de préférence de façon plane.

9. Dispositif selon l'une des revendications 1 à 7, **caractérisé en ce que** l'embout (2) est conçu en forme de cône, avec une cavité hélicoïdale ou en forme de spirale (21) s'étendant de façon excentrique par rapport à l'axe du cône et moulée dans la surface extérieure du cône (20).

10. Dispositif selon l'une des revendications précédentes 1 à 7, **caractérisé en ce que** l'embout (2) comporte une surface de base essentiellement plane, avec une pièce de guidage en forme de rail (30) disposée sur celle-ci et des cavités longitudinales (31) prévues dans celle-ci.

11. Dispositif selon l'une des revendications 1 à 7, **caractérisé en ce que** l'embout (2) présente la forme d'un champ de commande plat avec une cavité tridimensionnelle en forme de S (50) moulée dans celui-ci.

12. Dispositif selon l'une des revendications précédentes, **caractérisé en ce que** l'embout (2) et/ou la surface de capteur sont de préférence constitués de verre et/ou de plastique et/ou de carbone et/ou de bois ou autre.

13. Dispositif selon l'une des revendications précédentes, **caractérisé en ce que** le matériau de la surface d'embout est conçu pour recevoir des impressions et/ou des inscriptions.

14. Dispositif selon l'une des revendications précédentes, **caractérisé en ce que** le consommateur électrique est un volet roulant, un store, une marquise, une porte de garage, un ventilateur ou un dispositif d'éclairage électrique.

15. Procédé de commande d'un consommateur électrique comprenant une unité de capteur présentant une surface de capteur, laquelle unité de capteur est capable de générer un champ et de détecter des variations de champ sans contact afin de détecter des gestes d'un utilisateur, en particulier des gestes de la main ou des doigts, et une unité d'évaluation et de commande destinée à recevoir et à évaluer les signaux de l'unité de capteur et à commander le consommateur électrique, dans lequel un geste de la main ou des doigts est effectué selon une forme prédéfinie sur un embout tridimensionnel (2), et la forme d'onde générée ou la variation de champ est détectée par l'unité d'évaluation et de commande et comparée avec au moins une forme d'onde ou une variation de champ prédéfinie et le consommateur électrique étant actionné par l'unité d'évaluation et de commande en fonction de la comparaison des formes d'onde ou des variations de champ, l'embout (2) présentant au moins une cavité et/ou un bossage permettant de définir au moins un geste de l'utilisateur, **caractérisé en ce que** l'au moins une cavité et/ou l'au moins un bossage sur l'embout (2) présente un tracé tridimensionnel.

16. Procédé selon la revendication 15, **caractérisé en ce que** les perturbations agissant sur l'embout (2) sont compensées par le calibrage des signaux de l'unité de capteur.
